# FASCICULE DE BREVET EUROPEEN

(11) **EP 1 153 305 B1**
(45) Date de publication et mention de la délivrance du brevet: **04.12.2002**
(21) Numéro de dépôt: 00910680.8
(22) Date de dépôt: 15.02.2000
(51) Int. Cl.: G01R 19/00, G01R 31/34

(54) **DISPOSITIF DE MESURE DE COURANT ET PROCEDE CORRESPONDANT**
EINRICHTUNG ZUR STROMMESSUNG UND ZUGEHÖRIGES VERFAHREN
CURRENT MEASURING DEVICE AND CORRESPONDING METHOD

(30) Priorité: 18.02.1999 FR 9901979
(43) Date de publication de la demande: 14.11.2001
(73) Titulaire: Siemens VDO Automotive S.A.S., 31036 Toulouse cedex 01 (FR)
(72) Inventeur: BORTOLUSSI, Claude, F-31700 Blagnac (FR)
(74) Mandataire: Berg, Peter, Dipl.-Ing.
(86) Numéro de dépôt international: EP0001229
(87) Numéro de publication internationale: WO00049420

(56) Documents cités:
- PATENT ABSTRACTS OF JAPAN vol. 018, no. 246 (E-1546), 11 mai 1994 (1994-05-11) & JP 06 030579 A (MITSUBISHI ELECTRIC CORP), 4 février 1994 (1994-02-04)

## Description

L'invention se rapporte à un dispositif et à un procédé de mesure de courant impliquant l'amplification de signaux de faible valeur. Elle conceme notamment le domaine des directions assistées d'automobiles.

Bien que le dispositif le plus connu de direction assistée de véhicule automobile utilise un moteur électrique à courant continu, il est envisagé d'utiliser un moteur triphasé asynchrone.

Dans une direction assistée de véhicule automobile, il est indispensable, pour gérer la stratégie de commande, de connaître le couple appliqué par le moteur d'assistance, et donc, s'agissant d'un moteur triphasé, de connaître les courants électriques passant dans les trois phases. La mesure correspondante est effectuée à travers un shunt en utilisant la formule classique U = R x I.

Par ailleurs, lorsque le conducteur du véhicule tourne le volant lentement, on ne peut pas utiliser un rapport de démultiplication important entre l'arbre et la direction puisque il deviendrait très difficile pour le conducteur de tourner le volant en cas de panne du système. Il faut donc utiliser un moteur à fort couple (en particulier pour les véhicules "lourds"), même à faible vitesse, et lui appliquer une commande vectorielle qui est actuellement la seule qui permet un couple important à vitesse presque nulle.

En pratique, le moteur électrique utilisé présente une puissance qui peut être de l'ordre de 500 watts, et il est alimenté par une tension continue hachée (les trois phases sont obtenues par hachage sensiblement rectangulaire de la tension issue d'une batterie du véhicule, et lissage en utilisant l'effet self du moteur lui-même). La fréquence utilisée est de l'ordre de 15 à 25 KHz (soit sensiblement le haut de la bande audio standard).

Dans le but de mesurer la tension aux bornes d'un shunt monté en série sur une phase du moteur électrique (le shunt oscillant entre la masse et la tension batterie, à la fréquence de découpage), il est évidemment souhaitable de réduire la déperdition en chaleur par effet Joule dans le shunt (déperdition proportionnelle au carré de l'intensité électrique passant dans le shunt).

L'intensité étant ici de l'ordre de 100 Ampères, un shunt de 1 mΩ entraîne déjà une puissance dissipée en chaleur de 10 watts. On comprend donc que, de ce fait, la tendance est de rechercher à réduire encore la valeur du shunt.

La conséquence de ce choix de faible valeur de shunt est que la tension finalement mesurée aux bornes du shunt est, pour un shunt de 1 mΩ, de l'ordre de 100 mV.

Le problème est alors de réaliser sur le shunt une mesure de courant suffisamment précise à partir d'une tension dont l'ordre de grandeur est environ 100 mV, et qui intervient sur une tension hachée issue de la batterie de 12 V (le rapport est donc d'environ 1% entre la tension à mesurer et la tension hachée), et hachée à une fréquence élevée de l'ordre de 15 à 25 KHz, en présence de bruit sur la tension hachée, particulièrement à chaque choc de tension (front de tension montant ou descendant).

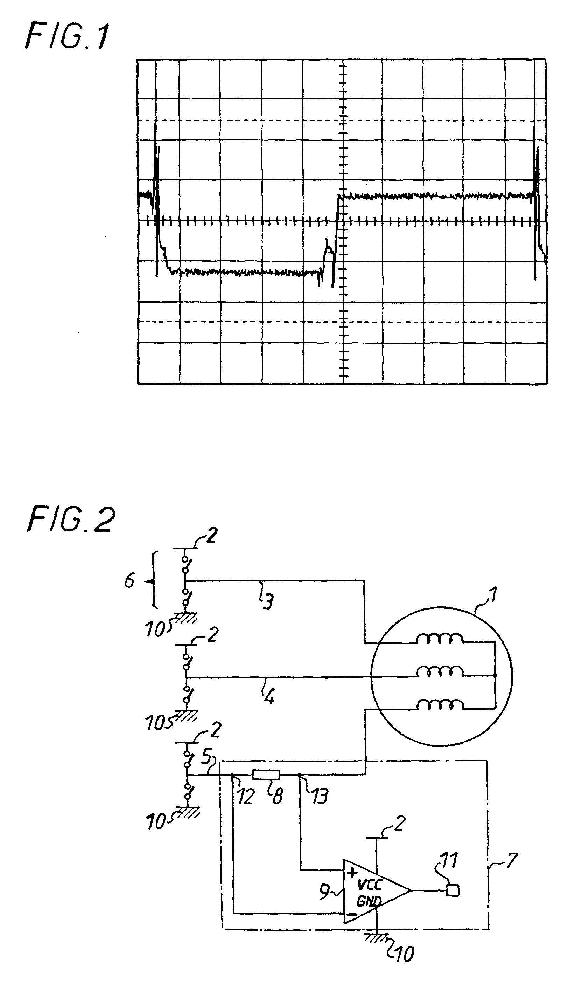

Les amplificateurs différentiels classiques ne permettent pas une lecture précise de la tension aux bornes du shunt, car la mesure est très perturbée à chaque transition de hachage. La figure 1 montre le signal obtenu par un tel amplificateur différentiel classique pour une valeur de courant maximum.

La présente invention répond au problème précédemment exposé, et propose à cet effet, avec le procédé correspondant, un dispositif simple à fabriquer et bon marché permettant l'amplification et la mesure de signaux faibles.

Suivant l'invention, pour une mesure de courant sur une ligne alimentée par une tension bruitée et comprenant un shunt monté en série, on met en oeuvre un amplificateur du signal du shunt, dit après amplificateur flottant, et un moyen pour alimenter ledit amplificateur flottant par une tension qui suit la tension d'alimentation du shunt.

On comprend que le principe de l'invention est d'amplifier le signal utile pour faciliter son extraction dans le signal de hachage. Pour ce faire, on alimente l'amplificateur du signal du shunt par une tension qui suit le potentiel du shunt.

L'invention vise de même, l'application du dispositif et du procédé faisant son objet à une mesure de courant sur une ligne d'alimentation d'un moteur asynchrone.

Selon des disposition particulières éventuellement utilisées en conjonction :
- le moteur électrique est de type triphasé,
- le moteur électrique est alimenté par une tension hachée,
- le moteur électrique a une puissance d'environ 500 watts,
- le shunt a une valeur d'environ 1 mΩ,
- le dispositif comprend un amplificateur différentiel dont les entrées sont reliées d'une part, à une borne d'entrée du shunt, et, d'autre part, à la sortie de l'amplificateur dit flottant,
- l'amplificateur flottant a ses entrées reliées aux bornes du shunt et est alimenté à travers un montage de type double bootstrap.

Ces dispositions sont favorables à une réalisation du dispositif avec des composants classiques, sans exigence particulière et donc bon marché, ce qui rend la fabrication du dispositif économique.

L'invention vise enfin, sous un autre aspect, l'application du dispositif et du procédé faisant son objet à une direction assistée électrique pour véhicule automobile.

S'agissant, d'une manière générale, d'une mesure de courant faible sur une ligne alimentée par une tension bruitée, et comportant un shunt monté en série, le procédé de l'invention est caractérisé en ce qu'il comporte une étape d'amplification du signal de différence de potentiel entre les bornes d'entrée et de sortie du shunt par un amplificateur alimenté par une tension qui suit la tension d'alimentation du shunt.

Préférentiellement, il comporte en outre un étape d'amplification différentielle de la différence entre, dune part, le signal de tension hachée en entrée du shunt, et, d'autre part, la différence de potentiel aux bornes du shunt, amplifiée par l'amplificateur flottant.

Il est important de noter que ce problème de mesure de courant faible dans le shunt en présence de bruit de tension est en fait nouveau dans une application de direction assistée électrique, dans la mesure où la plupart des dispositifs antérieurement existants utilisaient des moteurs à courant continu, de plus faible puissance (100 à 150 watts). Il ne se posait donc pas de problème particulier pour mesurer une tension aux bornes d'un shunt monté sur la masse ou la tension batterie (du fait de l'absence de hachage).

Les moteurs à courant continu actuels fonctionnent en utilisant des balais, qui présentent un problème d'usure, et qui ne seraient pas utilisables en pratique pour des moteurs de 500 watts. Par ailleurs, la volonté d'avoir un couple constant quelle que soit la direction, et de réduire les "oscillations de couple" actuellement existantes sur les directions assistées à moteur à courant continu à balais, conduit à utiliser des moteurs asynchrones triphasés, et donc à introduire une tension hachée, comportant un bruit de tension non négligeable.

L'invention s'applique donc plus généralement à tous les moteurs électriques dit "brushless" (sans balais), ou aux moteurs qui ne travaillent pas en courant continu.

La description et les dessins qui suivent permettront de mieux comprendre les buts et avantages de l'invention. Il est clair que cette description n'est donnée qu'à titre d'exemple, et n'a pas de caractère limitatif.

Dans les dessins:
- la figure 1 illustre le bruit présent sur une tension hachée alimentant un moteur électrique triphasé,
- la figure 2 représente schématiquement un dispositif de mesure d'un signal issu d'un shunt, non conforme à l'invention,
- la figure 3 représente schématiquement, de façon analogue, un dispositif de mesure selon l'invention,
- la figure 4 illustre le signal mesuré, après utilisation du dispositif selon l'invention.

Comme on le voit sur la figure 2, un moteur 1 asynchrone triphasé, par exemple destiné à agir sur une direction de véhicule automobile, est alimenté par une batterie 2 (de type 12 Volts) au travers de trois lignes d'alimentation 3, 4, 5. Un dispositif de hachage 6, de nature classique (interrupteur rapide), et non détaillé ici, est inséré sur chaque ligne d'alimentation du moteur 1, de même qu'un dispositif de commande (non représenté) du moteur 1.

On cherche donc à déterminer le courant circulant dans les lignes électriques 3, 4, 5. Pour ce faire, un dispositif 7 de mesure de courant faible est disposé sur une ligne (ici notée 5) d'alimentation du moteur 1.

Ce dispositif 7 comporte d'abord un shunt 8, de type classique, de valeur environ 1 mΩ, et un moyen d'amplification, qui dans la réalisation illustrée figure 2 et non conforme à l'invention, se compose d'un amplificateur différentiel 9, monté aux bornes 12, 13 du shunt 8 (borne "+" à la borne de sortie 13 de shunt, et borne "-" à la borne d'entrée 12 du shunt), et alimenté entre la batterie 2 et une masse 10. Un dispositif de traitement de la mesure 11, non détaillé ici, reçoit le signal émanant de l'amplificateur différentiel 9.

On a vu plus haut que l'utilisation d'un tel dispositif de mesure entraîne l'observation d'un signal tel que représenté figure 1, donc très bruité et difficilement exploitable.

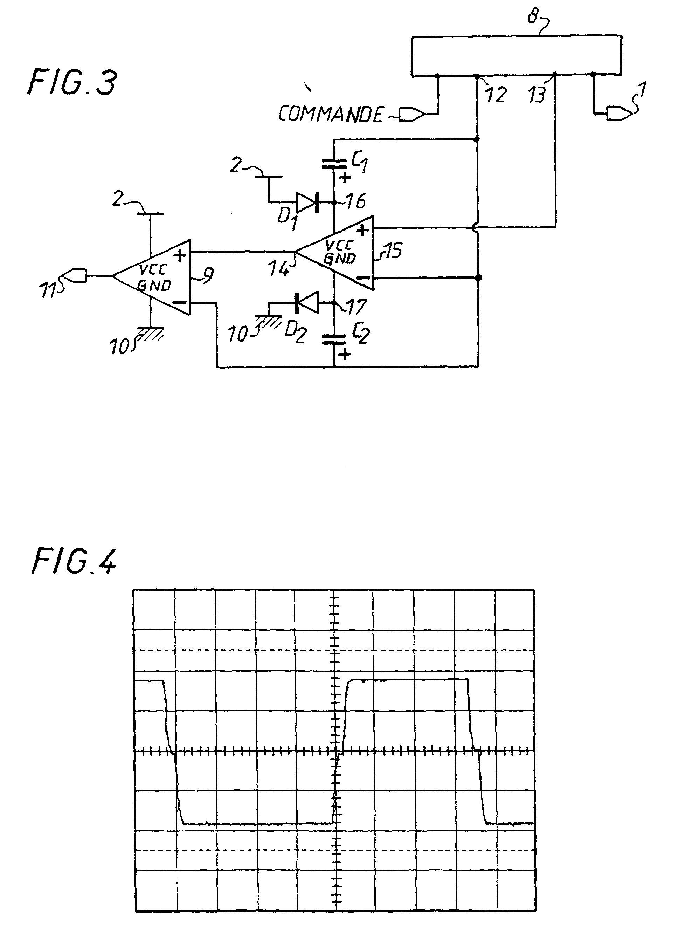

Le dispositif conforme à l'invention est alors illustré sur la figure 3. On constate qu'il comporte, outre l'amplificateur différentiel 9, dont les entrées sont reliées d'une part, pour la borne "-", à la borne d'entrée 12 du shunt 8, et, d'autre part, pour la borne "+", à la sortie 14, un amplificateur 15 dit flottant.

Cet amplificateur flottant 15 a ses entrées reliées aux bornes 12, 13 du shunt 8 (borne "+" à la bome de sortie 13 de shunt, et borne "-" à la borne d'entrée 12 du shunt). Il est alimenté par un moyen d'alimentation flottant constitué d'un montage de type double bootstrap.

Plus précisément, une borne de tension VCC dudit amplificateur flottant 15 est reliée à la batterie 2 à travers une diode D1. Un condensateur C1 est monté entre la borne d'entrée 12 du shunt et la cathode 16 de la diode D1.

De même, une borne de tension GND (ou VEE) de l'amplificateur flottant 15 est reliée à la terre 10 à travers une diode D2. Un condensateur C2 est monté entre la borne d'entrée 12 du shunt et l'anode 17 de la diode D2.

En fonctionnement, le signal issu de la batterie et haché présente une tension évoluant entre 0 et 12 Volts. Lors d'une altemance positive de hachage (sensiblement 12 Volts), on impose la tension batterie hachée (12+ΔU) sur le condensateur C2 d'alimentation "-" de l'amplificateur flottant 15, à travers la diode D2, et la tension Vee vaut alors sensiblement la tension en entrée du shunt (12+ΔU) (borne 12) MOINS 12 volts, soit ΔU. La tension Vcc vaut sensiblement la tension en entrée du shunt (12+ΔU) PLUS 12 Volts (décharge de C1), et la différence Vcc-Vee vaut 24 volts.

Lors d'une alternance négative de hachage (sensiblement 0 Volt), cette tension de batterie hachée 0+ΔU est appliquée sur le condensateur C1 d'alimentation "+" de l'amplificateur flottant 15, à travers la diode D1, et la tension Vcc vaut alors sensiblement la tension en entrée du shunt 0+ΔU (borne 12) PLUS 12 volts. La tension Vee vaut sensiblement la tension en entrée du shunt 0+ΔU (borne 12) MOINS 12 volts (décharge de C2), soit ΔU -12 Volts, et la différence Vcc-Vee vaut 24 volts, ici encore.

L'amplificateur flottant 15 est donc alimenté à une tension double de celle de la batterie 2, aux éléments de commutation près. Et cette alimentation suit le potentiel du shunt (indépendance vis à vis de ΔU, donc des chocs de hachage). On a donc bien réalisé ici une alimentation symétrique flottante de l'amplificateur flottant 15, qui suit le potentiel d'entrée du shunt 8.

L'amplificateur flottant 15 ainsi alimenté est donc apte à amplifier le signal entre les bornes du shunt 8, indépendamment du bruit existant sur la tension d'alimentation.

On amplifie alors par l'amplificateur flottant 15 le signal de différence de potentiel entre les bornes d'entrée 12 et de sortie 13 du shunt 8.

L'amplificateur différentiel 9 travaille quant à lui avec comme entrées d'une part le signal de tension hachée en entrée 12 du shunt 8, et d'autre part la différence de potentiel aux bornes du shunt 8, amplifiée par l'amplificateur flottant 15.

La comparaison entre ces signaux par un amplificateur différentiel 9 classique est alors beaucoup plus facile qu'en l'absence d'amplification de la différence de potentiel aux bornes 12, 13 du shunt 8.

En effet, en l'absence d'amplification de la différence de potentiel aux bornes du shunt 8, le bruit sur la tension d'alimentation est grand devant la différence de potentiel aux bornes du shunt (valeur à mesurer), et l'amplificateur différentiel est donc peu performant. Au contraire, après amplification de la différence de potentiel aux bornes du shunt, le bruit sur la tension d'alimentation devient peu important vis à vis du signal amplifié, et l'amplificateur différentiel est performant.

Autrement dit, il est possible de réaliser la mesure du courant avec de très faibles valeurs de shunt, car avec l'alimentation flottante réalisée, il est possible d'amplifier le faible signal obtenu, et de référencer ensuite ce signal amplifié par rapport à la masse générale, en minimisant les erreurs apportées par l'étage différentiel.

La figure 4 illustre la mise en oeuvre réelle de l'invention, avec un courant maximum, et on constate que les distorsions de commutations sont le reflet exact du comportement des interrupteurs de puissance.

Un avantage significatif de ce montage est qu'il est alors possible de se contenter d'un amplificateur différentiel 9 de type classique, et donc bon marché, et de même on utilise un amplificateur flottant 15 également classique et bon marché. Ceci contribue à réduire le coût de fabrication du dispositif.

## Revendications

1. Dispositif de mesure de courant sur une ligne (5) alimentée par une tension bruitée, comprenant un shunt (8) monté en série sur la ligne (5), **caractérisé en ce qu'**il comporte un amplificateur (15) du signal du shunt (8), dit après amplificateur flottant, et un moyen d'alimentation flottant (C1, C2, D1, D2) pour alimenter ledit amplificateur (15) par une tension qui suit la tension d'alimentation du shunt (8).

2. Dispositif selon la revendication 1, **caractérisé en ce que** la ligne (5) est une ligne d'alimentation d'un moteur électrique (1) triphasé asynchrone, ledit moteur électrique (1) étant alimenté par une tension hachée, ayant une puissance d'environ 500 watts, et **en ce que** le shunt (8) a une valeur d'environ 1 mΩ.

3. Dispositif selon l'une quelconque des revendications 1 à 2, **caractérisé en ce qu'**il comporte un amplificateur différentiel (9) dont les entrées sont reliées d'une part, à une borne d'entrée (12) du shunt (8), et, d'autre part, à la sortie (14) de l'amplificateur dit flottant (15).

4. Dispositif selon la revendication 3, **caractérisé en ce que** l'amplificateur flottant (15) a ses entrées reliées aux bornes (12, 13) du shunt (8) et **en ce que** le moyen d'alimentation flottant (C1, C2, D1, D2) est constitué d'un montage de type double bootstrap.

5. Dispositif selon la revendication 4, **caractérisé en ce que** le montage de type double bootstrap comporte :
la liaison d'une borne de tension VCC dudit amplificateur flottant (15) à une batterie (2) à travers une première diode (D1), et le montage d'un premier condensateur (C1) entre la borne d'entrée (12) du shunt et la cathode (16) de la première diode (D1),
la liaison d'une borne de tension GND (ou VEE) de l'amplificateur flottant (15) à la terre (10) à travers une seconde diode (D2) et le montage d'un condensateur (C2) entre la borne d'entrée (12) du shunt et l'anode (17) de la seconde diode (D2).

6. Dispositif selon la revendication 5, **caractérisé en ce que** l'amplificateur flottant (15) est alimenté à une tension double de la tension d'alimentation du shunt (8), avant hachage.

7. Utilisation d'un dispositif selon l'une quelconque des revendications 1 à 6, dans une direction assistée électrique pour véhicule automobile.

8. Procédé de mesure de courant faible sur une ligne (5) alimentée par une tension bruitée, **caractérisé en ce qu'**il comporte une étape d'amplification du signal de différence de potentiel entre les bornes d'entrée (12) et de sortie (13) du shunt (8) par un amplificateur (15) dit après amplificateur flottant, alimenté par une tension qui suit la tension d'alimentation du shunt (8).

9. Procédé selon la revendication 8, **caractérisé en ce que** il comporte en outre un étape d'amplification différentielle de la différence entre, d'une part, le signal de tension hachée en entrée (12) du shunt (8), et, d'autre part, la différence de potentiel aux bornes du shunt (8), amplifiée par l'amplificateur flottant (15).

## Claims

1. Device for measuring the current on a line (5) supplied by a noisy voltage, comprising a shunt (8) mounted in series with the line (5), **characterised in that** it comprises an amplifier (15) of the shunt (8) signal, hereinafter referred to as the floating amplifier, and a floating supply means (C1, C2, -D1, D2) for supplying said amplifier (15) by a voltage which follows the supply voltage of the shunt (8).

2. Device according to Claim 1, **characterised in that** the line (5) is a supply line of a three-phase asynchronous electric motor (1), said electric motor (1) being supplied by a chopped voltage and having a power of approximately 500 watts, and that the shunt (8) has a value of approximately 1 mΩ.

3. Device according to one of Claims 1 or 2, **characterised in that** it comprises a differential amplifier (9) whose inputs are connected to an input terminal (12) of the shunt (8) and to the output (14) of the floating amplifier (15) respectively.

4. Device according to Claim 3, **characterised in that** the floating amplifier (15) has its inputs connected to the terminals (12, 13) of the shunt (8) and that the floating supply means (C1, C2, D1, D2) is constituted by a circuit of the double bootstrap type.

5. Device according to Claim 4, **characterised in that** the double bootstrap circuit comprises:
- the connection of a VCC voltage terminal of said floating amplifier (15) to a battery (2) via a first diode (D1), and the mounting of a first capacitor (C1) between the input terminal (12) of the shunt and the cathode (16) of the first diode (D1).
- the connection of a GND (or VEE) voltage terminal of the floating amplifier (15) to earth (10) via a second diode (D2), and the mounting of a capacitor (C2) between the input terminal (12) of the shunt and the anode (17) of the second diode (D2).

6. Device according to Claim 5, **characterised in that** the floating amplifier (15) is supplied by a voltage double the supply voltage of the shunt (8), before chopping.

7. Use of a device according to one of Claims 1 to 6 in a motor vehicle power steering system.

8. Method of measuring low current on a line (5) supplied by a noisy voltage, **characterised in that** it comprises an amplification stage for the signal representing the potential difference between the input terminal (12) and output terminal (13) of the shunt (8) by an amplifier (15) hereinafter referred to as the floating amplifier, supplied by a voltage which follows the supply voltage of the shunt (8).

9. Method according to Claim 8, **characterised in that** it additionally comprises a differential stage for amplifying the difference between the chopped voltage signal at the input (12) of the shunt (8) and the potential difference across the terminals of the shunt (8), amplified by the floating amplifier (15).

## Patentansprüche

1. Vorrichtung zum Messen des Stroms in einer Leitung (5), an die eine verrauschte Spannung angelegt wird, mit einem Nebenschlusswiderstand (8), der in die Leitung (5) in Reihe geschaltet ist, **dadurch gekennzeichnet, dass** sie einen Verstärker (15) für das Signal des Nebenschlusswiderstandes (8), der im folgenden Floatingverstärker genannt wird, und ein Floating-Spannungsversorgungsmittel (Cl, C2, D1, D2) zum Versorgen des Verstärkers (15) mit einer Spannung, die der Versorgungsspannung des Nebenschlusswiderstandes (8) folgt, aufweist.

2. Vorrichtung nach Anspruch 1, **dadurch gekennzeichnet, dass** die Leitung (5) eine Versorgungsleitung eines Dreiphasen-Asynchron-Elektromotors (1) ist, der mit einer Zerhackerspannung versorgt wird, die eine Leistung von ungefähr 500 Watt hat, und dass der Nebenschlusswiderstand (8) einen Wert von ungefähr 1 mΩ hat.

3. Vorrichtung nach einem der Ansprüche 1 und 2, **dadurch gekennzeichnet, dass** sie einen Differentialverstärker (9) aufweist, dessen Eingänge einerseits mit einem Eingangsanschluss (12) des Nebenschlusswiderstandes (8) und andererseits mit dem Ausgang (14) des Floatingverstärkers (15) verbunden sind.

4. Vorrichtung nach Anspruch 3, **dadurch gekennzeichnet, dass** der Floatingverstärker (15) an seinen Eingängen mit den Anschlüssen (12, 13) des Nebenschlusswiderstandes (8) verbunden ist und dass das Floating-Spannungsversorgungsmittel (Cl, C2, D1, D2) von einer Double-Bootstrap-Schaltung gebildet wird.

5. Vorrichtung nach Anspruch 4, **dadurch gekennzeichnet, dass** die Double-Bootstrap-Schaltung aufweist:
die Verbindung eines Spannungsanschlusses VCC des Floatingverstärkers (15) mit einer Batterie (2) über eine erste Diode (D1) und die Schaltung eines ersten Kondensators (C1) zwischen den Eingangsanschluss (12) des Nebenschlusswiderstandes und die Kathode (16) der ersten Diode (D1),
die Verbindung eines Spannungsanschlusses GND (oder VEE) des Floatingverstärkers (15) mit Masse (10) über eine zweite Diode (D2) und die Schaltung eines Kondensators (C2) zwischen den Eingangsanschluss (12) des Nebenschlusswiderstandes und die Anode (17) der zweiten Diode (D2).

6. Vorrichtung nach Anspruch 5, **dadurch gekennzeichnet, dass** der Floatingverstärker (15) mit einer Spannung versorgt wird, die doppelt so groß wie die Versorgungsspannung des Nebenschlusswiderstandes (8) vor der Zerhackung ist.

7. Verwendung einer Vorrichtung nach einem der Ansprüche 1 bis 6 in einer elektrischen Servolenkung für ein Kraftfahrzeug.

8. Verfahren zum Messen eines Schwachstroms in einer Leitung (5), an die eine verrauschte Spannung angelegt wird, **dadurch gekennzeichnet, dass** es die Verstärkung des Signals der Potentialdifferenz zwischen den Eingangs(12)- und Ausgangs(13)-Anschlüssen des Nebenschlusswiderstandes (8) durch einen im folgenden Flöatingverstärker genannten Verstärker (15) umfasst, der mit einer Spannung versorgt wird, die der Versorgungsspannung des Nebenschlusswiderstandes (8) folgt.

9. Verfahren nach Anspruch 8, **dadurch gekennzeichnet, dass** es den Schritt einer differentiellen Verstärkung der Differenz zwischen einerseits dem Signal der Zerhackerspannung am Eingang (12) des Nebenschlusswiderstandes (8) und andererseits der Potentialdifferenz an den Anschlüssen des Nebenschlusswiderstandes (8), die durch den Floatingverstärker (15) verstärkt ist, umfasst.
